# EUROPEAN PATENT APPLICATION

(11) **EP 2 309 538 A2**
(43) Date of publication of application: **13.04.2011**
(21) Application number: 10251762.0
(22) Date of filing: 07.10.2010
(51) Int. Cl.: H01L 23/495

(54) **Package for semiconductor devices**

(30) Priority: 08.10.2009 US 575717
(71) Applicant: Power Integrations, Inc., San Jose, California 95138 (US)
(72) Inventor: Shelton, Bryan S., Bound Brook, NJ 08805 (US); Pabisz, Marek K., Quakertown, PA 18951 (US); Zhu, TingGang, Somerset, NJ 08873 (US); Liu, Linlin, Hillsborough, NJ 08844 (US); Peres, Boris, Somerset, NJ 08873 (US)
(74) Representative: Peterreins, Frank

(57) **Abstract**

A packaged semiconductor device (100) including a semiconductor die (105) mounted on a header (104) of a leadframe. A plurality of spaced external conductors (101, 103) extends from the header (104) and at least one of the external conductors (101, 103) has a bond wire pad (106, 107) at one end thereof such that a bonding wire (108, 109) extends between the bond wire pad (106, 107) and the semiconductor die (105). The package device (100) also includes a housing (115), which encloses the semiconductor die (105), the header (104), the bonding wire/s (108, 109) and the bonding wire pad/s (106, 107) resulting in an insulated packaged device (100).

## Description

### FIELD OF THE INVENTION

The present invention relates to packaged semiconductor devices, and more particularly to a lead frame and package enclosing a high power gallium nitride based semiconductor device.

### BACKGROUND OF THE INVENTION

Semiconductor devices such as diodes, field effect transistors and the like are commonly formed on semiconductor wafers/substrates which are later cut into dies containing individual devices or integrated circuits. The die has metallized pads or other electrodes which are electrically connected to source, gate, and drain regions in a transistor, or the anode and cathode in a diode. Most of the devices are formed on silicon (Si), silicon carbide (SiC), and gallium arsenide (GaAs) semiconductor wafers. All these substrates are electrically conducting which makes the devices made on such wafers "vertical devices", meaning they have electrical connections on the top and bottom surface of the die. To enable electrical connection to an external electronic circuit a semiconductor die is mounted inside a package made of the copper leadframe and the encapsulating epoxy. Examples of most common packages used for power semiconductor devices are well known industry standards for example TO-220, TO-247, DPAK, D2PAK, TO-263 or other package form factors.

As known in the art, the die is mounted onto the leadframe, which in turn provides electrical connection between the die and the bottom side of the package, and the mounting bracket on top of the encapsulated epoxy (in case of the TO220, TO247), and to at least one of the multiple external leads. Other electrical pads are connected to remaining external leads using wire bonds. At the end of the packaging, die and parts of the leadframe are encapsulated with insulating epoxy. Due to this configuration the end user in many applications needs to use additional elements to provide sufficient electrical insulation between package and the external hardware (heat sink) or other equipment which increases the cost of the final product.

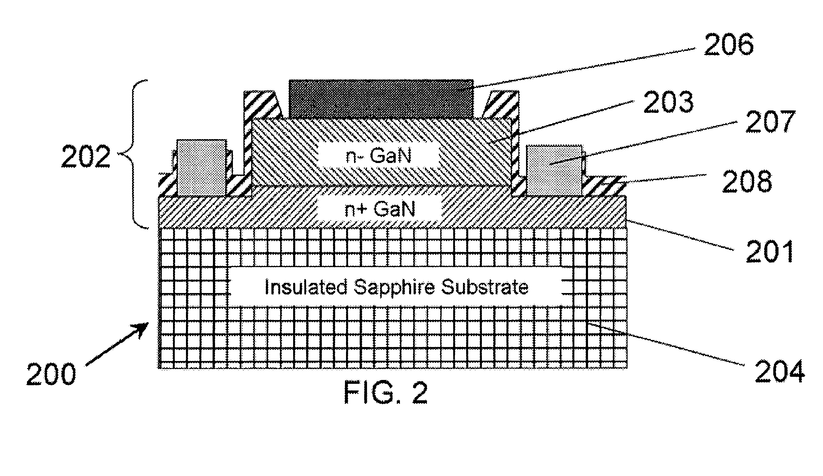

U.S. Pat. No. 6,847,058 to Ishizaka et al. discloses a MOSFET as a semiconductor device. In FIGS. 2 and 4 of Ishizaka, shows the device having a die 1 fixed to an upper surface of the header 13 through a drain (D) electrode. All three leads, source (S), gate (G) and drain (D) are electrically connected to the die 1. The S and the G are connected via bonding wires 16 while the D is the back side of the die 1 and is always electrically and mechanically connected to the lead frame, thus requiring electrical insulation on the back side of the device.

The development of gallium nitride semiconductor devices for use in optoelectronic, power and other applications have presented new packaging requirements for such devices, while manufacturing economics considerations and the desire of customers for pin-compatible components have dictated that such packages still conform to industry accepted packaging formats.

### SUMMARY OF THE INVENTION

Embodiments of the present invention provide an improved electrical performance in a package for a semiconductor device.

Embodiments of the present invention also provide a simplified and economically manufacturing assembly of the package for the semiconductor device.

Embodiments of the invention also provide a package for a semiconductor device conforming to industry accepted packaging formats.

Additional advantages, and novel features of the present invention will become apparent to those skilled in the art from this disclosure, including the following detailed description as well as by practice of the invention. While the invention is described below with reference to preferred embodiments, it should be understood that the invention is not limited thereto.

Briefly, and in general terms, the present invention provides a packaged semiconductor device including a semiconductor die mounted on a header of a leadframe. A plurality of spaced external conductors extends from the package and at least one of the external conductors has a bond wire pad/post at one end thereof such that a bonding wire extends between the bond wire pad/post and the semiconductor die. The packaged device also includes a housing, which encloses the semiconductor die, the header, the bonding wire(s) and the bonding wire pad(s)/post(s).

### BRIEF DESCRIPTION OF THE DRAWINGS

These and other features and advantages of this invention will be better understood and more fully appreciated by reference to the following detailed description when considered in conjunction with the accompanying drawings, wherein:
FIGS. 1A, 1B and 1C and 1D are perspective views of a sequence of the packaging of the semiconductor device resulting in a final product of a packaged semiconductor device in FIG. 1D according to an embodiment of the present invention.
FIG. 2 is a fragmentary, cross-sectional detailed view of a semiconductor structure of a semiconductor diode having the semiconductor die of FIGS. 1A-1D according to a preferred embodiment of the present invention.
FIG. 3 is a fragmentary, cross-sectional detailed view of a semiconductor structure of a semiconductor transistor having the semiconductor die of FIGS 1A-1D according to a preferred embodiment of the present invention.

### DESCRIPTION OF THE PREFERRED EMBODIMENT

Details of the present invention will now be described, including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of actual embodiments nor the relative dimensions of the depicted elements, and are not drawn to scale.

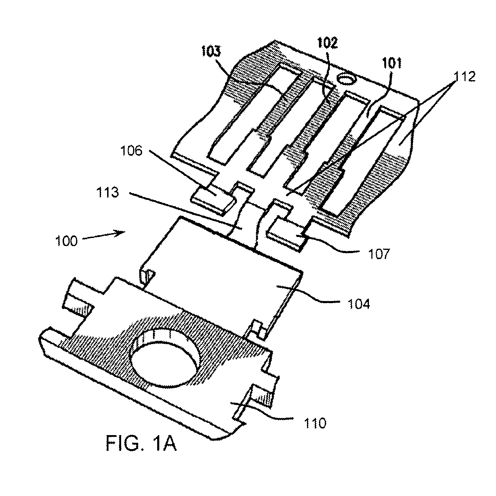

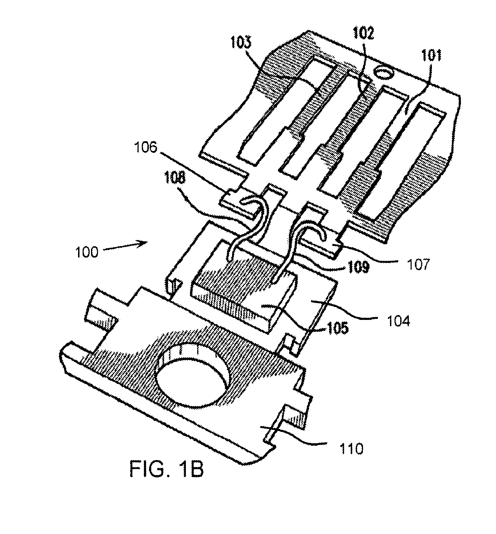

Referring to FIGS. 1A-1D there is shown a set of fragmentary, perspective views of a sequence of the packaging of the semiconductor device 100 in accordance with the present invention. A typical leadframe, used in the packaging is illustrated in FIG. 1A. It consists of the mounting bracket 110 and a header 104 which also serves a mounting support for a die. The packaging device 100 also includes external leads or electrodes 101, 102, and 103 parallel to each other and held together via excess metal 112. The lead 102 is permanently connected to the header 104 via the metal extension 113. Each of the leads 103 and 101 further includes wire bonding pads/posts 106 and 107 respectively. FIG. 1B further includes a semiconductor die 105 mounted on the header 104. As shown in FIG. 1B, bonding wires 108 and 109 are used to make electrical connection between active regions on the top surface of the semiconductor die 105 and the wire-bonding pads/posts 106 and 107 on the leads 103 and 101 respectively. Due to the insulating nature of the substrate there is no electrical connection between the die and the header 104, hence no electrical connection to the lead 102 and the mounting bracket 110.

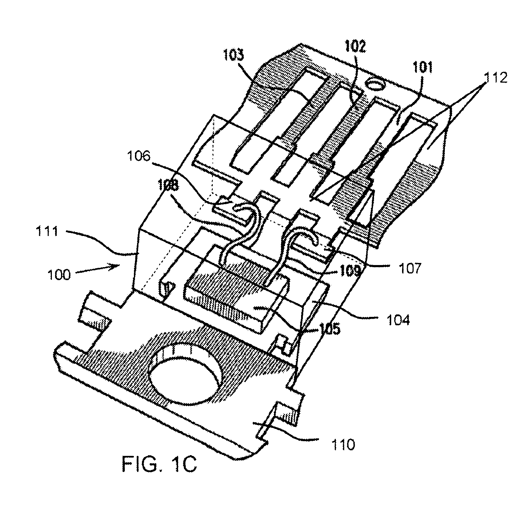

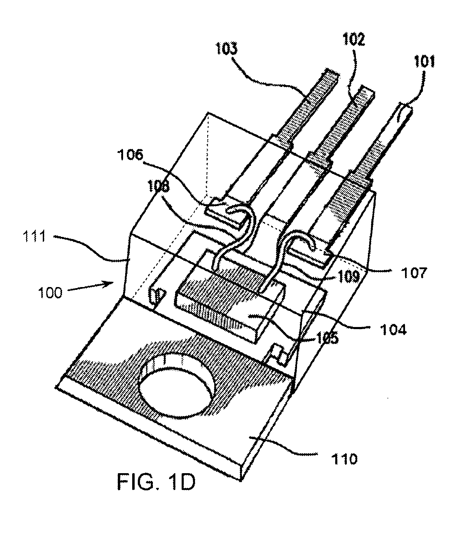

FIG. 1C shows a housing 111 made of a moulded plastic material such as an epoxy which encapsulates the die 105 and the wires 108 and 109 and a portion of the leads 101 and 103 including the bonding pads/posts 106 and 107 respectively. The housing 111 also functions to provide mechanical support for the leads 101 and 103 once the excessive and/or unused metal 112 is cut-off as shown in FIG. 1D.

FIG. 1D shows the final packaged semiconductor device 100 in which the excessive metal 112 is cut off such that the leads 101, 102 and 103 are independent and are no longer connected to each other via the metal 112. Also, by eliminating the excessive metal 112, the two outside leads 101 and 103 are not electrically connected to the header 104 and the mounting bracket 110. Thus, the final sealed packaged semiconductor device 100 in FIG. 10 provides complete insulation between the die 105 and the leadframe. Even though not displayed, the middle lead 102 may optionally be trimmed.

It is noted that the back side (not shown) of the header 104 remains uncovered which provides for a good thermal contact. This allows for the mounting of another element such as an external heat sink directly into the back side of the header 104 that would remove the heat generated in the die under normal operating conditions. In the prior art devices, the back side of the semiconductor packaged device is not isolated from the die and an insulator such as a Mylar film needs to be inserted between the device and the heat sink to avoid electrical connection between the two. However, in the present invention, such an insulator is not required since the leads 101 and 103 are floating and clearly not connected to the backside of the sealed package device 100 resulting in an insulated packaged device.

Referring to FIG. 2, there is shown a fragmentary, cross-sectional detail of the semiconductor GaN based diode structure 200 as the die 104 of FIG. 1 according to a preferred embodiment of the present invention. The structure 200 comprising a high power Gallium Nitride based diode 202 fabricated preferably on a sapphire (A1203) substrate 204. The diode 202 includes a highly doped (n+) layer 201 at the bottom and a lower doped (n-) layer 203 on top. As shown, an anode 206 is formed on the lowly doped (n-) layer 203 and a cathode 207 is formed only on the portions of the highly doped (n+) layer 201. A layer of dielectric 208 serves as a passivation to protect the die from the external elements (moisture, gases). It also provides electrical insulation between the two contacts. The anode 206 and a cathode 207 also serve as bonding pads on the die itself.

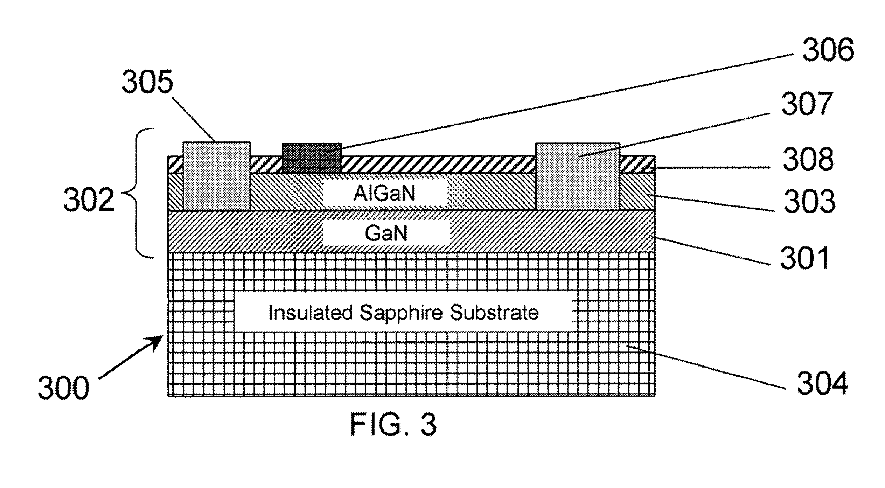

Referring to FIG. 3, there is shown a fragmentary, cross-sectional detail of the GaN based field effect transistor (FET) structure 300 as the die 104 of FIG. 1 according to another preferred embodiment of the present invention. The structure 300 comprising a high power Gallium Nitride based FET 302 fabricated on the sapphire (A1203) substrate 304. The FET 302 includes GaN layer 301 at the bottom and the AIGaN layer 303 on top. As shown in FIG. 3, a gate (G) electrode 306 is formed on the AlGaN layer 303 and the source (S) and drain (D) electrodes 305 and 307 respectively, are formed through the AlGaN layer 303 onto the GaN layer 301. A layer of dielectric 308 serves as a passivation to protect the die from the external elements. It also provides electrical insulation between the contacts. It is noted that the drawings on FIGS. 2 and 3 are for the illustration purposes only and are not too scale.

Even though, the GaN based devices shown are fabricated on a sapphire substrate, it is known to one skilled in the art that other semiconductor substrates like silicon (Si), silicon carbide (SiC) and like can be used. Sapphire substrates provide economical benefit comparing to silicon carbide substrates while at the same time enabling superior quality comparing to devices fabricated on silicon substrates. Additionally the sapphire substrates are electrically insulating, hence devices fabricated on such substrates will no longer be vertical devices. Unlike commercially available devices, gallium nitride based devices fabricated on a sapphire substrate have all bonding pads on the upper surface of the die. A fully fabricated die on sapphire is attached to the leadframe with epoxy or soldered if earlier process steps include back side metallization, which might be beneficial for some applications. Electrical connections are made between the bonding pads and the external leads not connected to the leadframe, keeping the die electrically insulated from the frame. Later the die is encapsulated with epoxy and unused parts of the lead frame are cut off.

It is also within the scope of the invention that multiple wires go from the die's bonding pads to external leads not connected to the header. Therefore, in case of the diode, there can be more than one bonding wire from the anode, and more than one bonding wire from the cathode, depending on the die configuration and type of bonding wire used. In addition, multiple GaN based devices can also be incorporated into one package, including any combination of diodes and FETs to meet the needs of integration and the industry. Wirebond connections may be made between those devices and between devices and external leads connected to the header. Any number of die can be included in the package, assuming that they will fit into the allotted space.

In the preferred embodiment, two 0.25 mm (10 mil) aluminium wires are used. However, for higher surge current capability a 0.38 mm (15 mil) Al wires may preferably be used. In other embodiments, the wire may be made of gold and be as small as 50 µm (2 mil).

The method and device of the present invention described herein can thus be utilized in association with devices and/or other semiconductor device structures to improve reliability, control and stability thereof. The present invention thus applies to any semiconductor device utilizing mesa structures defining active regions, and in particular III-V semiconductor devices.

While the invention has been illustrated and described as a packaged semiconductor device for a gallium nitride based structure, it is not intended to be limited to the details shown, since various modifications and structural changes may be made without departing from the scope of the present invention. Further, it will be apparent to those skilled in the art that various modifications and variations may be made in the apparatus and process of the present invention without departing from the scope of the invention. Thus, it is intended that the present invention cover all such modifications and variations within the scope of the appended claims.

## Claims

1. An insulated semiconductor packaging device (100) comprising:
a leadframe comprising a header (104) connected to a mounting bracket (110);
at least one semiconductor die (105) mounted to the header (104) of the leadframe;
at least two spaced external conductors (101,103) extending from said header (104) such that the at least two spaced external conductors are not electrically connected to the header (104) of the leadframe, said one (101) of the at least two spaced external conductors (101,103) is substantially parallel to the other (103) of the at least two spaced external conductors;
at least a first bonding wire (109) being electrically connected between the die (105) and said one (101) of the at least two spaced external conductors (103) not electrically connected to the leadframe and at least a second bonding wire (108) being electrically connected between the die (105) and the other (103) of the at least two spaced external conductors (101,103) not electrically connected to the header of the leadframe so that the die is electrically insulated from the leadframe; and
a housing (111) enclosing said die (105) and said at least first and second bonding wires (108,109), said housing (111) providing mechanical support to the at least two spaced external conductors (101,103).

2. The device of claim 1 wherein said one (101) of the at least two spaced external conductors (101,103) having a first wire bonding pad (107) at one end and the other (103) of the at least two spaced external conductors having a second wire bonding pad (106) at one end.

3. The device of claim 2 wherein said at least first bonding wire (109) extends from said at least one semiconductor die (105) to said first wire bonding pad (107) and said second bonding wire (108) extends from said semiconductor die (105) to said second wire bonding pad (108).

4. The device of claim 3 wherein said housing (115) encloses said first and second wire bonding pads (107,106).

5. The device of claim 1 further comprising a third spaced external conductor (102) extending parallel to the at least two spaced external conductors (101,103), wherein said third spaced external conductor (102) is connected to the header (104) via a metal extension (113).

6. A device as defined in claim 1, wherein said at least one semiconductor die (105) is directly attached to the leadframe by solder or thermally conductive epoxy.

7. The device of claim 1 wherein said at least one semiconductor die is:
(a) at least one diode (200);
(b) at least one semiconductor die is at least one transistor (300); or
(c) a combination of at least one diode and at least one transistor.

8. A device as defined in claim 1 wherein said at least one semiconductor die has a top surface and a bottom surface, said top surface including a planar semiconductor layer (202;302) and said bottom surface including a sapphire substrate (204;304), said planar semiconductor layer (202;302) comprising a lower semiconductor layer (201;301) and an upper semiconductor layer (203;303) disposed over a portion of said lower semiconductor layer, said lower semiconductor layer (201) and said upper semiconductor layer (203) being of the same conductivity type and said lower semiconductor layer (201) being more highly doped than said upper semiconductor layer (203).

9. A device as defined in claim 8, wherein said upper and lower semiconductor layers (203,201) are composed of gallium nitride based material.

10. The device of claim 8 wherein said at least one semiconductor die (105) is at least one diode (200) comprising an anode (206) formed on the upper semiconductor layer (203) and a cathode (207) formed on portions of the lower semiconductor layer (201).

11. The device of claim 10 further comprising a dielectric layer formed on the lower and upper semiconductor layers (208) devoid of the anode (206) and the cathode (207).

12. The device of claim 8, wherein said upper semiconductor layer (303) is composed of aluminium gallium nitride and the lower semiconductor layer (301) is composed of gallium nitride.

13. The device of claim 8 wherein said at least one semiconductor die (105) is at least one transistor (300) comprising a gate electrode (306) formed on the upper semiconductor layer (303), and a source electrode (305) and a drain electrode (307) which are formed through the upper semi-conductor layer (303) onto the lower semiconductor layer (301).

14. The device of claim 13 further comprising a dielectric layer (308) formed on the upper semiconductor layer (303) devoid of the gate (306), the source and the drain electrodes (305,307).

15. The device of claim 1 wherein the rear side of the header provides for a direct thermal contact.
